# EUROPÄISCHE PATENTANMELDUNG

(11) **EP 0 594 041 A1**
(43) Veröffentlichungstag der Anmeldung: **27.04.1994**
(21) Anmeldenummer: 93116512.0
(22) Anmeldetag: 12.10.1993
(51) Int. Cl.: H05K 9/00

(54) **Befestigung einer Abschirmung mit einer Leiterplatte**

(30) Priorität: 23.10.1992 DE 9214394 U
(71) Anmelder: SIEMENS AKTIENGESELLSCHAFT, D-80333 München (DE)
(72) Erfinder: Brink, Ludger, Dipl.-Ing., D-45721 Haltern (DE)

(57) **Zusammenfassung**

Auf der Leiterplatte (1) ist eine den Konturen der Abschirmung (2) entsprechende durchgehende Lötfläche (3) aufgebracht, die mit der Abschirmung (2) verbunden werden soll.
Zu diesem Zweck wird auf die Lötfläche (3) eine Lötpaste aufgetragen, auf die die Abschirmung (2) aufgesetzt wird. Anschließend wird die Abschirmung (2) unter kurzfristiger hoher Wärmeeinwirkung (Reflow-Lötverfahren) mit der Leiterplatte verbunden.

## Beschreibung

Die vorliegende Erfindung beinhaltet die Befestigung einer HF-mäßigen metallischen und rahmenartigen Abschirmung auf einer Bauteile aufnehmenden Leiterplatte, wobei auf der Leiterplatte eine den Konturen der Abschirmung entsprechende durchgehende Lötfläche aufgebracht ist.

Bei mit Hochfrequenz betriebenen Geräten, z. B. schnurlosen Telefonen oder Funktelefonen, müssen die die Hochfrequenz abstrahlenden Baugruppen in der Weise abgeschirmt werden, daß störende Einflüsse ausgeschlossen werden. Derartige Abschirmungen bestehen zumeist aus einer die auf einer Leiterplatte aufgebrachte HF-Baugruppe umfassenden rahmenartigen und aus Metall bestehenden Abdeckung, auf die nach deren Befestigung auf der Leiterplatte ein die Abdeckung teilweise umfassender Deckel aufgebracht wird. Die dem Deckel gegenüberliegende Seite der Leiterplatte ist üblicherweise auf ihrer der Baugruppe abgewandten Rückseite mit einer metallischen und als Abschirmung dienenden Beschichtung versehen.

Bisher erfolgte die Befestigung der rahmenartigen Abschirmung durch an ihr angeordnete Blechlappen, die durch entsprechende Durchbrüche der Leiterplatte hindurchgreifen oder im Randbereich der Leiterplatte zur Anlage gelangen und anschließend umgebogen werden. Eine weitere Art der Befestigung besteht darin, an der Abschirmung Rastelemente vorzusehen, die mit entsprechenden Gegenrasten an der Leiterplatte zusammenarbeiten. Ferner ist es bekannt, auf der Leiterplatte eine den Konturen der Abschirmung entsprechende durchgehende Lötfläche aufzubringen, die anschließend durch Erwärmen mittels eines Lötkolbens mit der Abschirmung verbunden wird.

Alle bisher aufgeführten Verbindungsarten weisen jedoch den Nachteil auf, daß sie einen nicht unerheblichen Material- und Zeitaufwand erfordern.

Der vorliegenden Erfindung liegt daher die Aufgabe zugrunde, eine Verbindung aufzuzeigen, durch die die Herstellungskosten gerade bei Massenprodukten erheblich reduziert werden können.

Diese Aufgabe wird dadurch gelöst, daß die Lötfläche mit einer Lötpaste versehen ist, und die auf die Lötpaste aufgesetzte Abschirmung mit der Leiterplatte unter kurzfristiger hoher Wärmeeinwirkung (Reflow-Lötung) verbunden ist.

Bei dieser Befestigung einer Abschirmung auf einer Leiterplatte wird die Abschirmung lediglich auf die die Lötpaste aufweisende Lötfläche aufgesetzt und anschließend im Reflow-Lötverfahren mit der Leiterplatte verbunden. Beim bekannten Reflow-Lötverfahren wird eine Lötverbindung zwischen zwei Teilen durch Einwirkung von kurzfristiger hoher Erwärmung, die z. B. in einem Infrarotofen erzeugt werden kann, bewirkt. Diese Verbindung kann somit in einem Fertigungsautomaten hergestellt werden, so daß sich der Arbeits- und Zeitaufwand erheblich verringern läßt.

Die Erfindung soll im folgenden anhand eines Ausführungsbeispiels näher erläutert werden.

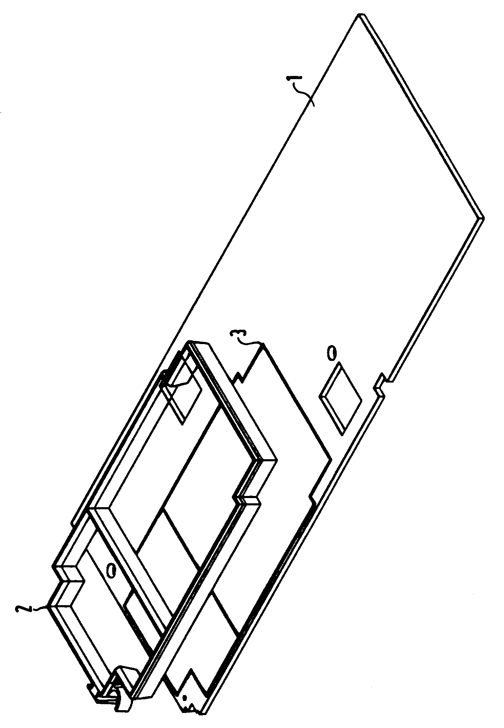

Die Abbildung zeigt in perspektivischer Darstellung die Befestigung einer metallischen Abschirmung auf einer Leiterplatte.

Mit der Leiterplatte 1 soll die rahmenförmige und aus Metall bestehende Abschirmung 2 durch Löten verbunden werden. Zu diesem Zweck weist die Leiterplatte 1 eine den Konturen der Abschirmung 2 entsprechende durchgehende Lötfläche 3 auf. Auf diese Lötfläche 3 wird eine Lötpaste aufgetragen. Die rahmenförmige Abschirmung 2 wird anschließend auf die die Lötpaste aufweisende Lötfläche 3 aufgesetzt. Die Verbindung von Leiterplatte 1 und Abschirmung 2 erfolgt im Reflow-Lötverfahren, d. h. durch Löten unter kurzfristiger hoher Wärmeeinwirkung.

Die HF-mäßige Abschirmung der in dem rahmenartigen Bauteil 2 angeordneten Baugruppe gegenüber benachbarten oder in der näheren Umgebung angeordneten, auf Strahlung empfindlichen Bauteilen kann einerseits durch Aufsetzen eines metallischen Deckels (hier nicht dargestellt) auf den Rahmen und andererseits durch Vorsehen einer metallischen Abschirmung innerhalb einer aus mehreren Lagen bestehenden Leiterplatte erfolgen.

## Patentansprüche

1. Befestigung einer HF-mäßigen, metallischen und rahmenartigen Abschirmung (2) mit einer Bauteile aufnehmenden Leiterplatte (1), wobei auf der Leiterplatte (1) eine den Konturen der Abschirmung (2) entsprechende durchgehende Lötfläche (3) aufgebracht ist, **dadurch gekennzeichnet,** daß die Lötfläche (3) mit einer Lötpaste versehen ist und die auf die Lötpaste aufgesetzte Abschirmung (2) mit der Leiterplatte (1) unter kurzfristiger hoher Wärmeeinwirkung (Reflow-Lötung) verbunden ist.
